# EUROPÄISCHE PATENTSCHRIFT

(11) **EP 1 354 326 B1**
(45) Veröffentlichungstag und Bekanntmachung des Hinweises auf die Patenterteilung: **15.08.2007**
(21) Anmeldenummer: 02735101.4
(22) Anmeldetag: 22.01.2002
(51) Int. Cl.: H01B 7/08, B60R 16/02, H01R 35/02

(54) **FLEXIBLES FLACHBANDKABEL UND VERFAHREH ZUR SEINER HERSTELLUNG**
FLEXIBLE STRIP CABLE AND METHOD OF MANUFACTURING IT
CABLE PLAT FLEXIBLE ET METHODE DE FABRICATION IDOINE

(30) Priorität: 27.01.2001 DE 10103761
(43) Veröffentlichungstag der Anmeldung: 22.10.2003
(73) Patentinhaber: Leopold Kostal GmbH & Co. KG, 58507 Lüdenscheid (DE)
(72) Erfinder: LETTMANN, Holger, 58840 Plettenberg (DE); KAMINSKI, Dean, 44227 Dortmund (DE)
(86) Internationale Anmeldenummer: PCT/EP2002/000574
(87) Internationale Veröffentlichungsnummer: WO 2002/073633

(56) Entgegenhaltungen:
- EP-A- 0 520 245
- US-A- 4 652 772
- US-A- 4 696 523

## Beschreibung

Die Erfindung betrifft ein flexibles Flachbandkabel mit mehreren parallel zueinander zwischen zwei isolierenden Deckfolien angeordneten elektrischen Leitern. Ferner betrifft die Erfindung eine bevorzugte Verwendung eines solchen flexiblen Flachbandkabels sowie eine Wickelfederkassette ausgerüstet mit einem solchen Flachbandkabel. Gegenstand der Erfindung ist ferner ein Verfahren zum Herstellen eines solchen flexiblen Flachbandkabels.

Flexible Flachbandkabel bestehen aus mehreren parallel zueinander angeordneten elektrischen Leitern, die zwischen zwei isolierenden Deckfolien angeordnet sind. Die Deckfolien sind üblicherweise durch ein Klebemittel miteinander verbunden und schließen somit die elektrischen Leiter zwischen sich ein. Die elektrischen Leiter sind voneinander beabstandet und durch den Kleber und/oder die Deckfolien voneinander isoliert. Die elektrischen Leiter können als im Querschnitt zumeist rechteckige oder quadratische Kupferleiter ausgebildet sein oder im Wege eines Druckvorganges auf die untere Deckfolie aufgetragen worden sein. Eingesetzt werden solche flexiblen Flachbandkabel in zahlreichen Anwendungen als Anschlußkabel, insbesondere in solchen Fällen, in denen nur ein geringer Einbauraum zur Verfügung steht. Flexible Flachbandkabel finden jedoch auch Einsatz in solchen Vorrichtungen, in denen zwei gegeneinander bewegliche Elemente in elektrischer Verbindung miteinander stehen, wie dies beispielsweise bei einer Wickelfederkassette eines Kraftfahrzeuges der Fall ist. Eine solche Wickelfederkassette umfaßt einen drehfest mit der Lenkspindel verbundenen Rotor und einen mit dem Mantelrohr verbundenen Stator und dient zum Herstellen einer elektrischen Verbindung zwischen dem statorseitigen Bordnetz und den in einem Lenkrad integrierten elektrischen/elektronischen Komponenten. Innerhalb einer solchen Wickelfederkassette ist das Flachbandkabel unter Ausbildung einer U-förmigen Umbiegung aufgewickelt dergestalt, daß mehrere Lenkradumdrehungen möglich sind. Zu diesem Zweck ist das eingesetzte Flachbandkabel sehr flexibel ausgebildet. Bei einigen vorbekannten Wickelfederkassetten ist stator- und rotorseitig das in der Wickelfederkassette eingesetzte Flachbandkabel an einem dem jeweiligen Teil - Rotor oder Stator - zugeordneten Steckverbindungsteil angeschlossen. Bei einer Montage der Wi-Ausgehend von diesem diskutierten Stand der Technik liegt der Erfindung daher die Aufgabe zugrunde, ein eingangs genanntes, gattungsgemäßes flexibles Flachbandkabel dergestalt weiterzubilden sowie ein Verfahren zum Herstellen eines flexiblen Flachbandkabels vorzuschlagen, daß eine abschnittsweise Verstärkung des Flachbandkabels automatisiert erfolgen kann.

Diese Aufgabe wird dadurch gelöst, daß in einem oder mehreren Abschnitten des Flachbandkabels eine auf zumindest eine Deckfolie aufgebrachte flexible Verstärkungsfolie angeordnet ist sowie durch ein Verfahren, welches gekennzeichnet ist dadurch, daß sich an dem Schritt des Verbindens der Deckfolien miteinander und dem damit einhergehenden ckelfederkassette an der Lenksäule erfolgt eine Kontaktierung durch entsprechende Gegensteckverbindungsteile. Es sind weitere Wickelfederkassetten bekannt geworden, bei denen rotorseitig das eingesetzte Flachbandkabel aus der Wickelfederkassette soweit herausgeführt ist, daß dieses bis zur nächsten Verbindungsstelle reicht. Bei einer solchen Ausgestaltung ist dann die zuvor beschriebene elektrische Verbindungsstelle am Rotor der Wickelfederkassette vermieden. Das aus der Wickelfederkassette herausgeführte Flachbandkabel ist in einzelne Kabeläste aufgetrennt, mit denen unterschiedliche Steckverbinder kontaktiert werden können. Zum Schutze der einzelnen Kabeläste sind diese kunststoffumspritzt. Zusätzlich wird eine Manschette benötigt, in die derjenige Abschnitt des Flachbandkabels aufgenommen ist, in dem die Verästelung beginnt. Die Manschette dient ebenfalls dem Schutze des darin eingelegten Flachbandkabels.

Das Umspritzen von flexiblen Werkstücken, insbesondere eines sehr flexiblen Flachbandkabels, wie etwa solche, die in eine Wickelfederkassette eingesetzt sind, gestaltet sich jedoch aufwendig, da ein Einsetzen der einzelnen Kabeläste in die Spritzgußformen nur manuell möglich ist. Da es notwendig ist, vor dem Umspritzen der einzelnen Kabeläste diese durch Auftrennen bzw. durch Aufspleißen des Flachbandkabels zunächst auszubilden, ist die Handhabung der einzelnen Kabeläste aufgrund ihrer hohen Flexibilität umständlich, insbesondere wenn mehrere solcher Kabeläste an dem aus der Wickelfederkassette herausgeführten Flachbandkabelende vorgesehen sind.

Durch die US-Patentschrift 4,652,772 ist ein elektrisches Flachbandkabel gemäß dem Oberbegriff des Patentanspruchs 1 bekannt geworden. Das dort aufgezeigte Flachbandkabel, welches insbesondere für Energiever-sorgungsleitungen im Hausbereich vorgesehen und mit einer inneren, die einzelnen Leiter voneinander isolierenden, aus zwei Deckfolien bestehenden Isolationsschicht versehen ist, ist zum Zwecke der Verlegung unter einem Teppich auf seiner gesamten Länge mit einem zusätzlichen, äußeren Isolationsmantel umgeben.

Einschließen der parallel zueinander verlaufenden elektrischen Leiter der Schritt des Auftragens einer Verstärkungsfolie auf zumindest einer Deckfolie anschließt, wobei die Verstärkungsfolie in einem Abschnitt des zuvor erstellten Flachbandkabels aufgetragen wird.

Bei dem erfindungsgemäßen flexiblen Flachbandkabel ist zum Schutze der beispielsweise aus einer Wickelfederkassette herausgeführten Kabelabschnitte vorgesehene, diese durch Aufbringen einer Verstärkungsfolie auf zumindest einer Deckfolie oder auch auf beiden Deckfolien zu schützen. Durch diese Maßnahme erfolgt nicht nur eine Verstärkung der Isolierung sondern ebenfalls wird dieser Abschnitt in Abhängigkeit von der Ausgestaltung der eingesetzten Verstärkungsfolie versteift. Der Vorteil bei einem solchen Flachbandkabel ist, daß das Aufbringen einer Verstärkungsfolie im Gegensatz zum Umspritzen gemäß dem vorbekannten Stand der Technik sehr viel unproblematischer durchführbar ist, und insbesondere durchgeführt werden kann, bevor - wie bei einem Einsatz eines solchen Flachbandkabels in einer Wickelfederkassette in einzelne Äste vorgesehen - dieses Ende des Flachbandkabels aufgetrennt wird. Aufgetrennt wird dann jedoch nicht ein Flachbandkabel mit sehr flexiblen Eigenschaften, sondern ein solches, welches zumindest einseitig mit einer Verstärkungsfolie beschichtet ist. Dadurch ist die Handhabung erheblich er leichtert. Besonders vorteilhaft ist bei einem solchen Flachbandkabel, daß das Aufbringen der zumindest einen abschnittsweise vorgesehenen Verstärkungsfolie bereits bei der Herstellung des Flachbandkabels und somit mit den bei einem Hersteller ohnehin vorhandenen Maschinen vorgenommen werden kann. Zusätzliche anders geartete Verfahrensschritte werden zum Herstellen des erfindungsgemäßen Flachbandkabels grundsätzlich nicht benötigt. Da ein bevorzugtes, jedoch nicht ausschließliches Einsatzgebiet für ein solches Flachbandkabel der Einsatz in einer Wickelfederkassette eines Kraftfahrzeuges mit herausgeführten Leiterbahnen ist, ist auf diese bevorzugte Verwendung ein Verwendungsanspruch gerichtet. Ebenfalls ist aus diesem Grunde eine Wickelfederkassette mit einem solchen Flachbandkabel beansprucht.

Nachfolgend ist die Erfindung anhand eines Ausführungsbeispieles unter Bezugnahme auf die beigefügten Figuren beschrieben. Es zeigen:
- Fig. 1:: Eine schematisierte Darstellung einer Einrichtung zum Herstellen eines flexiblen Flachbandkabels,
- **Fig. 2:**: Einen Längsschnitt durch einen Abschnitt eines mit der Einrichtung der Figur 1 hergestellten Flachbandkabels,
- **Fig. 3:**: Einen Querschnitt durch das Flachbandkabel der Figur 2 entlang der Linie A-B und
- **Fig. 4:**: Das Flachbandkabel der Figur 2 ausgestaltet als Einsatz für eine Wickelfederkassette eines Kraftfahrzeuges.

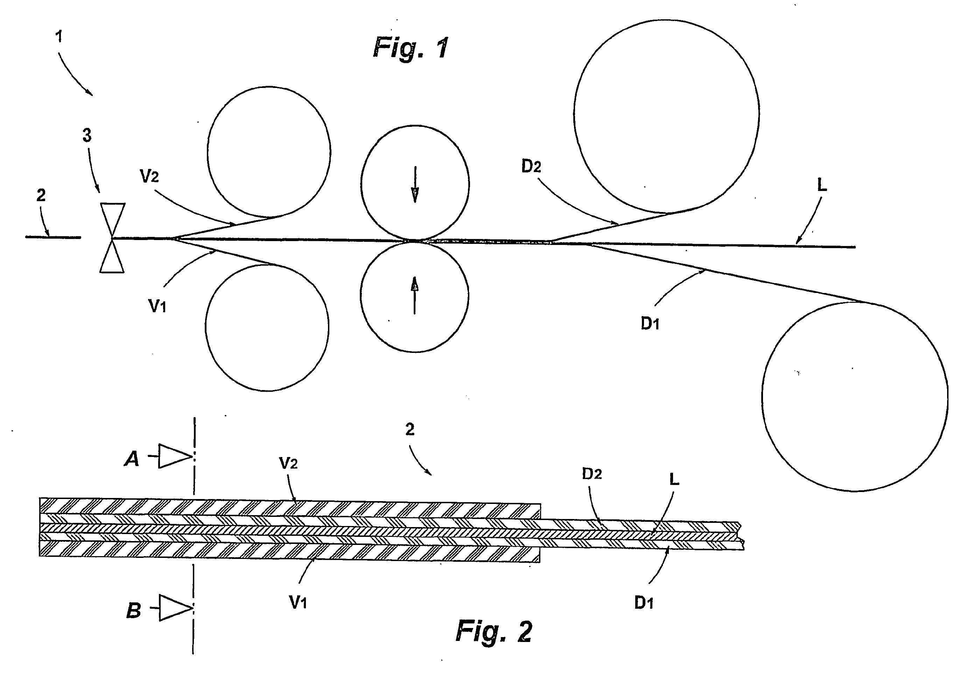

Eine Einrichtung 1 dient zum Herstellen eines flexiblen Flachbandkabels 2 im Wege eines Laminierverfahrens. Mit der Einrichtung 1 werden zwischen zwei Deckfolien D₁, D₂ mehrere parallel zueinander verlaufende elektrische Leiterbahnen L mit quadratischer oder rechteckförmiger Querschnittsfläche angeordnet. Die Deckfolien D₁, D₂ werden von entsprechenden Rollen abgespult, wobei die beiden zueinander weisenden Seiten der Deckfolien D₁, D₂ mit einem Kleber beschichtet sind, um einen Verbund zwischen den beiden Deckfolien D₁, D₂ zu ermöglichen. In einem diesem Laminierschritt nachgeschalteten Schritt werden mit der Einrichtung 1 auf jede der beiden Deckfolien D₁, D₂ in Abschnitten Verstärkungsfolien V₁, V₂ auflaminiert, bevor in einer Schneidestation 3 eine Längenkonfektionierung des produzierten Flachbandkabels 2 erfolgt. Ein mit der Einrichtung 1 hergestelltes Flachbandkabel 2 besteht somit aus einem Abschnitt bestehend aus den beiden Deckschichten D₁, D₂ mit den dazwischen befindlichen elektrischen Leitern L und einem weiteren Abschnitt, in dem zusätzlich die Verstärkungsfolien V₁, V₂ aufgebracht worden sind. Diese Ausgestaltung des Flachbandkabels 2 ist in einem Abschnitt in Figur 2 dargestellt. In dem dargestellten Ausführungsbeispiel befinden sich die Verstärkungsfolien V₁, V₂ in einem mit dem Bezugszeichen 4 bezeichneten Endabschnitt des Flachbandkabels 2. Bei der späteren Verwendung des Flachbandkabels 2 ist vorgesehen, daß im Bereich des Endabschnittes 4 das Flachbandkabel 2 in einzelne Kabeläste aufgeteilt werden soll. Der Abschnitt des Flachbandkabels 2 ohne Verstärkungsfolien ist sehr flexibel ausgestaltet und ist zum Einsatz in einer Wickelfederkassette eines Kraftfahrzeuges vorgesehen. Dieser Abschnitt des Flachbandkabels 2 ist in seiner späteren Verwendung in der Wickelfederkassette aufgenommen und bedarf daher keines zusätzlichen Schutzes durch die Verstärkungsfolien V₁, V₂. Hingewiesen sei darauf, daß das Flachbandkabel 2 auch im Bereich seines End-abschnittes 4 mit den beiden Verstärkungsfolien V₁, V₂ nach wie vor flexibel ist.

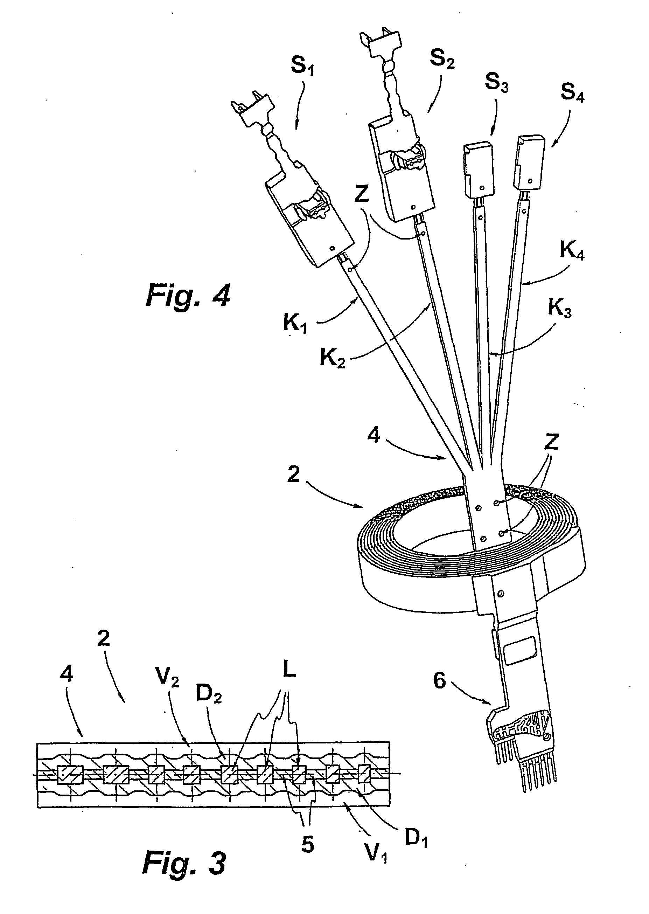

Der in Figur 3 gezeigte Querschnitt des Flachbandkabels 2 zeigt nochmals die elektrischen Leiter L zwischen den beiden Deckfolien D₁, D₂ und die auf den Deckfolien D₁, D₂ aufgebrachten Verstärkungsfolien V₁, V₂. Ferner ist erkennbar, daß zwischen den beiden Deckfolien D₁, D₂ ein Klebemittel 5 vorhanden ist, welches nicht nur zur Verbindung der beiden Deckschichten D₁, D₂ dient sondern auch zur Isolierung von zwei benachbarten Leitern L voneinander.

Das Flachbandkabel 2 dient - wie bereits oben erwähnt - zum Einbau in eine nicht näher dargestellte Wickelfederkassette eines Kraftfahrzeuges, in der es in etwa in der in Figur 4 gezeigten Anordnung eingebaut wird. Das Flachbandkabel 2 ist in der Wickelfederkassette aufgerollt und zwar dergestalt, daß der Endabschnitt 4 mit den Verstärkungsfolien V₁, V₂ den rotorseitigen Abgang definiert. Das andere Ende des Flachbandkabels 2 stellt den statorseitigen Abgang dar; an diesem Ende ist das Flachbandkabel 2 mit einem Steckerteil 6 ausgerüstet. Der Endabschnitt 4 führt aus der eigentlichen Wickelfederkassette rotorseitig heraus, so daß durch diesen Endabschnitt 4 gleichzeitig die Anschlußleitung zum Kontaktieren der nächsten Steckverbindung realisiert ist. In dem Endabschnitt 4 ist das Flachbandkabel 2 zur Ausbildung einzelner Kabeläste K₁ - K₄ aufgetrennt, damit diese individuell an unterschiedliche Steckverbinder angeschlossen werden können. An dem Ende jedes Kabelastes K₁ - K₄ ist ein Steckverbindungsteil S₁ - S₄ angebracht. Die Auftrennung des Flachbandkabels 2 im Bereich des Endabschnittes 4 ist so ausgestaltet, daß ein unterer, nicht aufgetrennter Bereich verbleibt, in dem ebenfalls das Flachbandkabel 2 mit Verstärkungsfolien V₁, V₂ beschichtet ist. In diesem Bereich sowie im Bereich eines jeden freien Endes eines Kabelastes K₁- K₄ sind Zugentlastungsöffnungen Z eingebracht. In einer in den Figuren nicht dargestellten Ausgestaltung ist vorgesehen, daß auch der statorseitige Anschluß der Wickelfederkassette entsprechend dem Endabschnitt 4 ausgebildet ist, so daß das dann auf die durch das Steckerteil 6 gebildete Schnittstelle verzichtet werden kann.

Das erfindungsgemäße Flachbandkabel ist, wie am Beispiel eines Einsatzes in einer Wickelfederkassette zeigt, zweckmäßig in solchen Anwendungsfällen einzusetzen, in denen flexible Flachbandkabel mit abschnittsweise unterschiedlicher Flexibilität benötigt werden.

### Bezugszeichenliste

- 1: Einrichtung zum Herstellen eines Flachbandkabels
- 2: Flachbandkabel
- 3: Schneidestation
- 4: Endabschnitt
- 5: Kleber
- 6: Steckerteil

- D₁, D₂: Deckfolie
- K₁ - K₄: Kabelast
- L: Leiterbahn
- S₁ - S₄: Steckverbindungsteil
- V₁, V₂: Verstärkungsfolie
- Z: Zugentlastungsöffnung

## Patentansprüche

1. Flexibles Flachbandkabel mit mehreren parallel zueinander zwischen zwei isolierenden Deckfolien (D₁, D₂) angeordneten elektrischen Leitern (L), **dadurch gekennzeichnet, daß** in einem oder mehreren Abschnitten des Flachbandkabels (2) eine auf zumindest eine Deckfolie (D₁, D₂) aufgebrachte flexible Verstärkungsfolie (V₁, V₂) angeordnet ist.

2. Flachbandkabel nach Anspruch 1, **dadurch gekennzeichnet, daß** das Flachbandkabel (2) im Bereich der aufgebrachten Verstärkungsfolien (V₁, V₂) in einzelne Kabeläste (K₁ - K₄) aufgetrennt ist.

3. Flachbandkabel nach Anspruch 1 oder 2, **dadurch gekennzeichnet, daß** in das Flachbandkabel (2) in den Endbereichen des oder der mit der Verstärkungsfolie (V₁, V₂) versehenen Abschnitte (4) Zugentlastungsöffnungen (Z) eingebracht sind.

4. Flachbandkabel nach einem der Ansprüche 1 bis 3, **dadurch gekennzeichnet, daß** das Flachbandkabel (2) in dem oder den mit der Verstärkungsfolie (V₁, V₂) versehenen Abschnitten (4) beidseitig mit einer Verstärkungsfolie (V₁, V₂) beschichtet ist.

5. Verwendung eines flexiblen Flachbandkabels nach einem der Ansprüche 1 bis 4, **gekennzeichnet dadurch, daß** dieses in eine Wickelfederkassette eines Kraftfahrzeugs eingesetzt ist, wobei ein beidseitig mit einer Verstärkungsfolie (V₁, V₂) versehener Abschnitt (4) des Flachbandkabels (2) aus der Wickelfederkassette herausgeführt und dieser Abschnitt in einzelne Kabeläste (K₁ - K₄) aufgetrennt ist, an deren freien Enden jeweils elektrische Verbindungsmittel (S₁ - S₄) angeordnet sind.

6. Wickelfederkassette für ein Kraftfahrzeug mit einem Rotor und einem Stator sowie mit einem flexiblen Flachbandkabel (2) nach einem der Ansprüche 1 bis 4 zum Herstellen einer elektrischen Verbindung zwischen dem Rotor und dem Stator, **dadurch gekennzeichnet, daß** das flexible Flachbandkabel (2) aus dem Rotor und/oder Stator herausgeführt ist und zumindest im Bereich eines herausgeführten Abschnittes (4) zumindest einseitig mit einer Verstärkungsfolie (V₁, V₂) beschichtet ist.

7. Wickelfederkassette nach Anspruch 6, **dadurch gekennzeichnet, daß** die aus der Wickelfederkassette herausgeführten Abschnitte (4) des Flachbandkabels (2) in einzelne Kabeläste (K₁ - K₄) aufgetrennt ist.

8. Verfahren zum Herstellen eines flexiblen Flachbandkabels nach einem der Ansprüche 1 bis 4, **dadurch gekennzeichnet, daß** sich an dem Schritt des Verbindens der Deckfolien (D₁, D₂) miteinander und dem damit einhergehenden Einschließen der parallel zueinander verlaufenden elektrischen Leiter (L) der Schritt des Auftragens einer Verstärkungsfolie (V₁, V₂) auf zumindest einer Deckfolie (D₁, D₂) anschließt, wobei die Verstärkungsfolie (V₁, V₂) in einem Abschnitt des zuvor erstellten Flachbandkabels (2) aufgetragen wird.

9. Verfahren nach Anspruch 8, **dadurch gekennzeichnet, daß** dem Schritt des Auftragens der Verstärkungsfolie(n) (V₁, V₂) ein Schritt des Konfektionierens eines Flachbandkabels (2) nachgeschaltet ist, der gleichfalls ein Auftrennen eines mit einer Verstärkungsfolie (V₁, V₂) versehenen Abschnittes (4) der zunächst im Flachbandkabel (2) vereinten Leiterbahnen (L) in einzelne Kabeläste (K₁ - K₄) mit einem oder mehreren elektrischen Leitern (L) umfaßt.

## Claims

1. Flexible flat ribbon cable with several electric conductors (L) arranged parallel to each other between two insulating covering foils (D₁, D₂), **characterised by** the fact that a flexible reinforcement foil (V₁, V₂) superimposed on at least one covering foil (D₁, D₂) is arranged in one or more segments of the flat ribbon cable (2).

2. Flat ribbon cable in accordance with Claim 1, **characterised by** the fact that the flat ribbon cable (2) is split into individual cable branches (K₁ - K₄) in the region of the superimposed reinforcement foils (V₁, V₂).

3. Flat ribbon cable in accordance with Claim 1 or Claim 2, **characterised by** the fact that, in the end regions of the segment or segments (4) provided with the reinforcement foil (V₁, V₂), strain relief holes (Z) are let into the flat ribbon cable (2).

4. Flat ribbon cable in accordance with any of Claims 1 to 3, **characterised by** the fact that the flat ribbon cable (2) is covered on both sides with a reinforcement foil (V₁, V₂) in the segment or segments (4) provided with the reinforcement foil (V₁, V₂).

5. Application of a flexible flat ribbon cable in accordance with any of Claims 1 to 4, **characterised by** the fact that the same is utilised in a coil spring cassette of a motor vehicle, wherein a segment (4) of the flat ribbon cable (2) provided on both sides with a reinforcement foil (V₁, V₂) is led out of the coil spring cassette and this segment is split into individual cable branches (K₁ - K₄), at each free end of which electrical connector elements (S₁- S₄) are arranged.

6. Coil spring cassette for a motor vehicle having a rotor and a stator and with a flexible flat ribbon cable (2) in accordance with any of Claims 1 to 4 for the purpose of establishing an electrical connection between the rotor and the stator, **characterised by** the fact that the flexible flat ribbon cable (2) is led out of the rotor and/or the stator and, at least in the region of a led-through segment (4), is covered on at least one side with a reinforcement foil (V₁, V₂).

7. Coil spring cassette in accordance with Claim 6, **characterised by** the fact that the segments (4) of the flat ribbon cable (2) that are led out of the coil spring cassette are split into separate cable branches (K₁-K₄).

8. Process for manufacturing a flexible flat ribbon cable in accordance with any of Claims 1 to 4, **characterised by the fact** that the step of affixing the covering foils (D₁, D₂) to each other and the associated enclosure of the electric conductors (L) running parallel to each other is succeeded by the step of superimposing a reinforcement foil (V₁, V₂) onto at least one covering foil (D₁, D₂), with the reinforcement foil (V₁, V₂) being superimposed in a segment of the previously produced flat ribbon cable (2).

9. Process in accordance with Claim 8, **characterised by** the fact that the step of superimposing the reinforcement foil or foils (V₁, V₂) is succeeded by a step of assembling a flat ribbon cable (2) which likewise entails splitting a segment (4) of the conductor paths (L) provided with a reinforcement foil which was initially united in the flat ribbon cable (2) into separate cable branches (K₁ - K₄) with one or more electric conductors (L).

## Revendications

1. Câble plat flexible agencé, avec plusieurs conducteurs électriques (L) disposés parallèlement les uns par rapport aux autres, entre deux feuille de recouvrement isolantes (D₁, D₂), **caractérisé en ce que**, dans une ou plusieurs sections du câble plat (2), est disposée une feuille de renforcement flexible (V₁, V₂) qui est appliquée sur au moins une feuille de recouvrement (D₁, D₂).

2. Câble plat selon la revendication 1, **caractérisé en ce que** le câble plat (2) est divisé en brins de câble individuels (K₁ - K₄), dans la zone de la feuille de renforcement (V₁, V₂) appliquée.

3. Câble plat selon revendication 1 ou 2, **caractérisé en ce que**, dans le câble plat (2), aux extrémités de la ou des sections (4) pourvues de la feuille de renforcement (V₁, V₂), sont agencés des orifices de décharge de traction (Z).

4. Câble plat selon l'une des revendications 1 à 3, **caractérisé en ce que**, dans la ou les sections (4) pourvues de la feuille de renforcement (V₁, V₂), le câble plat (2) est revêtu des deux côtés d'une feuille de renforcement (V₁, V₂).

5. Utilisation d'un câble plat flexible selon l'une des revendications 1 à 4, **caractérisée en ce que** celui-ci est logé dans une cassette à ressort en spirale d'un véhicule automobile, une section (4) dudit câble plat (2), pourvue des deux côtés, d'une feuille de renforcement (V₁, V₂), étant conduite hors de la cassette à ressort en spirale, et **en ce que** cette section est divisée en brins de câble (K₁ - K₄) individuels, aux extrémités libres desquels des moyens de connexion électriques (S₁ - S₄) sont respectivement agencés.

6. Cassette à ressort en spirale pour un véhicule automobile, avec un rotor et un stator, ainsi qu'avec un câble plat flexible (2) selon l'une des revendications 1 à 4, pour la réalisation d'une connexion électrique entre le rotor et le stator, **caractérisée en ce que** le câble plat flexible (2) est conduit hors du rotor et / ou du stator, et est revêtu, au moins d'un côté, avec une feuille de renforcement (V₁, V₂), au moins dans la zone d'une section (4) amenée à l'extérieur.

7. Cassette à ressort en spirale selon la revendication 6, **caractérisée en ce que** les sections (4) du câble plat (2), conduites hors de la cassette à ressort en spirale, sont divisées en brins de câble individuels (K₁- K₄).

8. Procédé pour la fabrication d'un câble plat flexible selon l'une des revendications 1 à 4, **caractérisé en ce que** l'étape de liaison des feuilles de recouvrement (D₁, D₂) l'une avec l'autre et l'insertion simultanée des conducteurs électriques (L), s'étendant parallèlement les uns par rapport aux autres, sont suivies de l'étape d'application d'une feuille de renforcement (V₁, V₂) sur au moins une feuille de recouvrement (D₁, D₂), ladite feuille de renforcement (V₁, V₂) étant appliquée dans une section du câble plat (2) précédemment fabriqué.

9. Procédé selon la revendication 8, **caractérisé en ce que** l'étape de l'application de la (des) feuille (s) de renforcements (V₁, V₂) est suivie d'une étape de confection d'un câble plat (2) laquelle comprend également une division d'une section (4), pourvue d'une feuille de renforcement (V₁, V₂), dans laquelle les conducteurs (L), qui étaient d'abord réunis dans le câble (2), sont séparés en brins de câble (K₁ - K₄) individuels à un ou plusieurs conducteurs électriques (L).
